# EUROPEAN PATENT APPLICATION

(11) **EP 1 416 546 A1**
(43) Date of publication of application: **06.05.2004**
(21) Application number: 02023464.7
(22) Date of filing: 21.10.2002
(51) Int. Cl.: H01L 41/083, B32B 18/00, H01L 41/24, C04B 35/491

(54) **Method of making a laminated ceramic with a non-planar structure**

(71) Applicant: Friedrich-Alexander-Universität Erlangen-Nürnberg, 91054 Erlangen (DE); Haiku Tech Holding B.V., 6274 NN Reijmerstok (NL)
(72) Inventor: Höppener, Roderik Hubrecht, 6274 NN Reijmerstok (NL); Oostra, Hendrikus, 6116 CC Roosteren (NL); Roosen, Andreas, 91054 Erlangen (DE); Wagner, Matthias, 96135 Stegaurach (DE)
(74) Representative: Gassner, Wolfgang, Dr.

(57) **Abstract**

The invention relates to a method of making a layered ceramic device comprising the steps of:
a) providing flexible green layers comprising a ceramic powder being bound by an organic binder,
b) stacking of the green layers,
c) laminating of the stacked green layers in a laminating step (L1) by applying a pressure in the range of 0,2 to 25 MPa and a temperature in the range of 20 to 220°C,
d) forming the laminate into a non-planar structure,
e) laminating the formed laminate in a further laminating step (L2), wherein in the further laminating step (L2) a pressure being higher than the pressure applied in the laminating step (L1) and/or a temperature being higher than the temperature applied the laminating step (L1) is applied, and
f) burning out of the organic binder and sintering.

## Description

The invention relates to a method of making a laminated ceramic with a non-planar structure. More particular, the invention concerns a method of making an electro-active device such as piezoelectric and piezoresistive devices having a non-planar structure.

Such electro-active devices are described for example in the International Publication WO 01/47041 A2. The devices described therein have been prepared mostly as bimorph devices. Bimorph devices consist of two laminated metallized lead zirconate titanate (PZT) layers. The manufacturing of such bimorph devices is described in Su, B. et al., Journal of the European Ceramic Society 21 (2001) 2005-2009. The bimorph devices are prepared by viscous polymer processing (VPP). Thereby a plastic ceramic mass is extruded and calendered to sheets of 200 µm up to 2 mm thickness. The VPP-process is limited to the manufacture of laminates comprising two green layers, because the green layers can not be manufactured accurately with thickness below 200 µm, the thin green layers exhibit not a sufficiently constant thickness compared to doctor-blade tape casting processes. Due to a high amount of organic additives the green layers show a relatively high shrinkage, shape instability and lack of process control.

In order to reduce the voltage supply it is desired to fabricate non-planar structures, in particular helical structures, from multilayer ceramic laminates made of thinner layers. However, laminated stacks of green ceramic layers tend to crack in particular when being formed into helical structures. A further problem is that a predetermined exact alignment of electrodes being applied on the layers is deorientated by forming the laminate.

An object of the present invention is to describe a method of making a laminated ceramic by which the disadvantages in the art are avoided. An aim of the present invention is in particular to provide an inexpensive and easily reproducible method for making a laminated ceramic, in particular an electro-active device.

This object is solved by the features of claims 1 and 4. Embodiments of the invention are described by the features of claims 2, 3 and 5 to 21.

According to a first aspect of the invention there is provided a method of making an laminated ceramic with a non-planar structure comprising the steps of:
providing flexible green layers comprising a ceramic powder being bound by an organic binder,
stacking of the green layers,
laminating of the stacked green layers in a laminating step (L1) by applying a pressure in the range of 0,2 to 25 MPa and a temperature in the range of 20 to 220°C,
forming the laminate into a non-planar structure,
laminating the formed laminate in a further laminating step (L2), wherein in the further laminating step (L2) a pressure being higher than the pressure applied in the laminating step (L1) and/or a temperature being higher than the temperature applied the laminating step (L1) is applied, and
burning out of the organic binder and sintering.

A "laminated ceramic" in the sense of the present invention comprises at least two ceramic layers being stacked one above the other and being bonded together by sintering. The layers may consist of different ceramic materials. There may be provided in between the layers metallic layers which may act as electrodes.

It has been surprisingly observed that an essentially planar laminate being manufactured by a laminating step (L1) with a relatively low pressure can be formed into a non-planar structure respectively shape without cracking. By applying a higher pressure and/or temperature in a subsequent further laminating step a further densification of the formed laminate is achieved. The non-planar structure of the laminate is fixed. Any elastic forces induced by bending the laminate are removed by the further laminating step (L2). This renders it possible to manufacture laminated ceramic devices of non-planar shape, in particular electro-active devices, in an inexpensive and easily reproducible way.

The pressure applied in the further laminating step (L2) may be in the range of 2 to 300 MPa. The temperature applied in the further laminating step (L2) may be in the range of 20 to 220°C.

According to a second aspect of the invention there is provided a method of making an laminated ceramic with a non-planar structure comprising the steps of:
providing flexible green layers comprising a ceramic powder being bound by a organic binder, wherein the green layer has a longitudinal extensibility of at least 17%,
stacking of the green layers,
laminating of the stacked green layers in a laminating step (L1) by applying a pressure in the range of 0,2 to 300 MPa and a temperature in the range of 20 to 220°C,
forming the laminate into a non-planar structure, and
burning out of the organic binder and sintering.

A green layer having a longitudinal extensibility of at least 17% may be manufactured by adjusting an appropriate ratio of ceramic powder:organic binder and/or the ratio of binder:plasticizer. The ratio/s strongly depend/s on the respective ceramic system. Starting from a conventional composition for a green layer of a given ceramic system one has to increase for example step by step the content of the organic binder until the necessary longitudinal extensibility is achieved. Thereby it has to be taken into account that the green density of the green layer is not lowered below a value that affects sinterability or the density of the sintered product.

The longitudinal extensibility of a green layer was determined by conventional strain-strength measurement until failure by a mechanical testing machine at feed speed of 1 mm/min and a layer thickness of 90 µm. The free clamping length of the mechanical testing machine is 50 mm. The measurement is made at room temperature.

Also by the second method of the invention no cracks occur when forming the laminate into a non-planar shape. It is assumed that by both methods of the present invention a laminate is provided in which the layers may be deformed plastically during bending.
The flexible green layer may be manufactured by the doctor-blade-, ceramic-filled-thermoreversible-polymeric-gel-foil- or calendering-process. The doctor-blade-process leads to tape cast green layers. By the ceramic-filled-thermoreversible-polymeric-gel-foil-process green layers are manufactured by stretching with ceramic powder filled polyethylene films to a thickness down to 1 µm. It is referred to the U.S.-Patent No. 5,268,415 the content of which is incorporated herewith. In any case there is provided a flexible green layer comprising a ceramic powder being bound by an organic binder. The organic binder may be in general a thermoplastic or soluble polymer or a binder dispersion. The organic binder may be selected from a group consisting of cellulose ether, polymerised alcohol, polymerised butyral, acrylic resin, polyvinyl acetate and polyethylene. The organic binder may be for example methyl cellulose, polyvinyl alcohol, polyvinyl butyral, or polyvinyl metacrylate. Further the green layer may contain plasticizer. By the addition of plasticizers the glass transformation temperature of the binder is lowered. Hence, thereby the flexibility of the green layer can be adjusted. It has been observed that a ratio of binder:plasticizer in the range of 1:0,75 to 1:3,5 is advantageous. A further laminating-step (L2) (see below) after forming is not always necessary when using a higher amount of plasticizer. Further it has been observed that a green layer with a thickness of 1 to 1000 µm may be used for the manufacture of an electro-active device according to the present invention.

The applying of an electrode layer on the surface of the green layers may be carried out in conventional manner. A metal paste can be screen-printed upon the surface of the green layer. Several electrodes may be printed on the surface of the green layers. In particular metal pastes forming tacky metallic layers are useful.

In order to achieve an exact alignment of the stacked green layers it is advantageous to cut the green layers to a uniform geometry. Further there may be provided position holes in the green layers. Such position holes facilitate in particular the alignment of electrodes being provided on the surface of the green layers, when stacking the green layers. Alternatively the green layers may be laminated on a carrier plate in a multilayer manner. The carrier plate serves for registration during an electrode printing step on each green layer being added. This method is also known as "print on stack method".

According to an essential feature of the invention the stacked green layers are laminated in a laminating-step (L1) before forming. The parameters of the laminating-step (L1) are adjusted in dependence of the number of the stacked green layers, the thickness of the green layers, the used binders, plasticizers etc.. The resulting laminate is flexible. It can be formed and bent with a little likelihood of cracking. It has been observed that it is advantageous to adjust in the laminating-step the pressure and/or temperature to create a laminate with a porosity of at least 3,0 Vol.%. Such a laminate may be infiltrated after the lamination step (L1) with plasticizer. Such an infiltration with plasticizer enhances further the flexibility of the laminate. The likelihood of cracking during forming is further reduced. The likelihood of cracking during forming may be also reduced when forming the laminate at a temperature in the range of 50 to 150°C. By heating up the laminate the viscosity of the binder is reduced. The flexibility of the laminate is increased.

According to a further embodiment of the invention the laminate is formed into the non-planar structure by placing it on a support structure. The support structure may be a cylindrical body or a body of any other cross-section. According to a further advantageous feature the laminate is fixed on the support structure. The fixing may be accomplished by such adhesives that do not affect the quality of the ceramic. By fixing the laminate on the support structure elastic forces of the bent laminate may be compensated, which may otherwise deform the laminate in an uncontrolled manner

According to a further embodiment a spacer made of organic material is placed between the support structure and the laminate. Such a spacer burns out during sintering process. Shrinkage of the formed laminate during sintering can be successfully compensated by the use of such a spacer. Otherwise cracks may occur and/or the sintered ceramic can not be removed from the support structure.

- The first and/or the second laminating step/s may be performed by isostatic pressing.

According to a further embodiment before step 1.3 or 4.3 an electrode layer may be applied on the surface of at least one of the green layers. This makes it in an easy way possible to manufacture a laminated ceramic being provided with electrodes within the ceramic layers. Such a laminated ceramic can be used for making electro-active devices. In the context of the present invention "electro-active devices" are devices which make use of components that display electro-active properties - that is, those in which a component changes shape in response to a change of the appropriate electrical conditions in which the component exists. Equally, the component may produce electrical signals in response to a shape change. The best known and most developed of these devices are piezoelectric devices. However, it will be understood that there are number of other sorts of electro-active devices including those that are electrostrictive or piezoresistive. Electrostrictive devices are formed from a material that contracts on the application of an electric field; piezoresistive materials change their electrical resistance when they change shape.

By the described method an electro-active device of non-planar structure can be manufactured at low costs. In particular helical structures can be realised. The electric-active device comprises a multilayer structure with at least 2, preferably at least 10, ceramic layers. Such a device can be operated with a low voltage supply. Helical structures made of electro-active multilayer laminates are excellent for the use in loudspeakers, phase shifters, optical devices etc..

Embodiments of the invention are now described by way of non-liminative examples with reference to the accompanying drawings in which:
- Fig. 1: is a flow chart illustrating the steps of a method according to the invention,
- Fig. 2: is a photograph of a helical structure on a cylindrical support,
- Fig. 3: is a photograph of a lateral view of a half pipe with a spacer-laminate,
- Fig. 4: is a photograph of a sintered helical structure,
- Fig. 5a: is a drawing of a first electrode design, and
- Fig. 5b: is a drawing of a second electrode design.

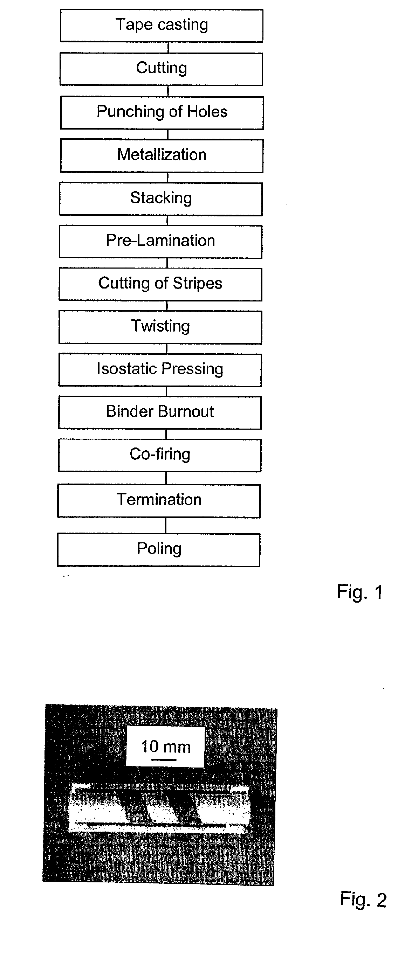

Fig. 1 shows a flow chart of a method according to the invention. A conventional flexible green layer manufactured i.e. by tape casting is provided. The green layer may comprise essentially a PZT-powder being bound by polyvinyl butyral containing a conventional plasticizer. The green layer can contain also as ceramic component any other material that exhibits in the sintered state i.e. piezoelectric, electrostrictive or piezoresistive properties.

The green layer is then cut in sheets of a predetermined geometry. Position holes are punched into the sheets. Then metallic layers are applied upon the surface of the sheets, i.e. by screen-printing of conventional metal pastes. The metallic layers form several electrodes on the surface. The sheets are stacked one upon the other using the position holes. In the stacked state the electrodes are in precise alignment. This allows a contacting of the electrodes as well as the application of terminals in a conventional manner.
The stack is then "pre-laminated" in a first laminating step (L1) by applying an uniaxial or isostatic pressure in the range of 0,2 to 20 MPa and a temperature of typically 50 to 135°C. The applied pressure and temperature depends essentially on the organic components used for the manufacture of the green layers.

However, it has been observed that it is advantageous to select the pressure and the temperature parameters so that the resulting laminate exhibits a porosity of more than 3,0 Vol.%. Such a laminate can be formed into a wide range in non-planar shapes without cracking. The laminate is typically made of about 20 to 100 green layers with a thickness of 1 to 200 µm.

The laminated sheets are cut into stripes. For forming purposes a support structure, i.e. a rod made of ceramic material is provided.

It has been observed that it is advantageous to provide a support structure with a smooth surface in order to minimise friction during the shrinkage of the ceramic during sintering. A smooth surface of the support structure also allows removing the sintered ceramic easily after sintering has been completed. It has been found advantages to choose a roughness value R_{A} for the surface smaller or equal 2 µm. More preferably the roughness value may be chosen smaller than 1/3 of the average grain size of the ceramic powder.

The rod is coated with a spacer-layer made of organic material. Such a spacer-layer may be applied by dipping the rod in a solution containing a polymer and a solvent. The thickness of the spacer-layer can be adjusted by the number of dippings and/or by the concentration of the solution. The spacer-layer may also be applied by spraying. As material for the spacer-layer an organic material is used which burns out without affecting the properties of the ceramic.

One of the stripes is then wound around the rod so that a helical structure is formed. The stripe may by fixed upon the rod, i.e. by using an adhesive, i.e. a double- or mono-sided adhesive tape. The stripe may also heated up to a temperature between 50°C and 150°C, typically 70°C, before forming. Thereby the flexibility, in particular the winding behaviour, of the stripe is improved.

Afterwards the laminate being placed on the support structure is further densified by isostatic pressing in a second laminating step (L2). The support structure with the laminate is vacuum-sealed in plastic bag or the like and than placed in an isostatic press. A pressure of 10 to 40 MPa and a temperature of about 130 to 180°C are applied. - It has to be understood that this second laminating step (L2) is an optional step, which improves usually the quality of the sintered ceramic. However, it has been observed that also without carrying out this second laminating step (L2) good results can be achieved.

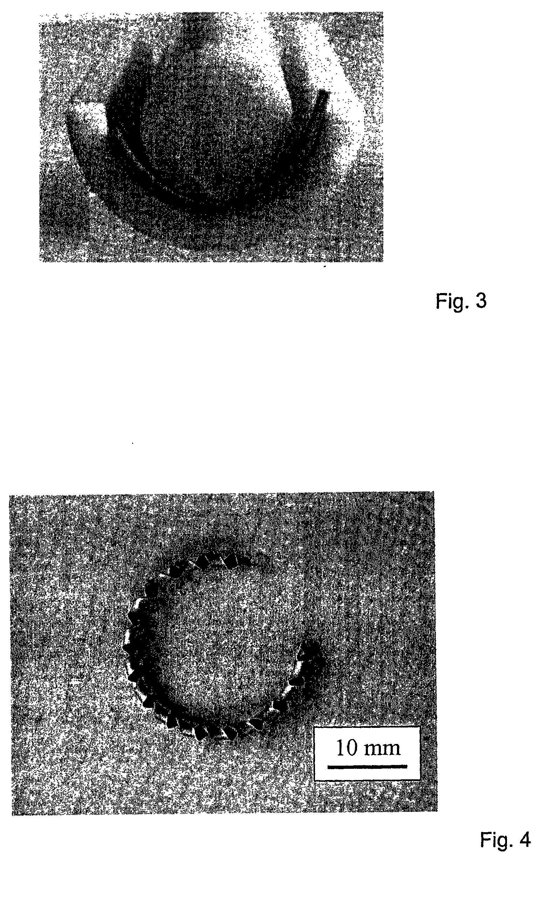

The support structure carrying the laminate is than placed in a suitable crucible, e.g. a cut tube or half pipe as depicted in Fig. 2. The cut tube is provided with spacers-laminate at both ends thereof (see Fig. 3) on which the support structure is supported. The spacer-laminates are made of the same laminate that was used for the manufacture of the structure to be sintered. Such a spacer-laminate exhibits during sintering the same shrinking rate as the laminate. Consequently the laminate being placed on the support structure will not be pressed on the surface of the half pipe by the weight of the rod. Thereby effectively an adhesion of the sintered ceramic to the half pipe can be prevented

The aforementioned arrangement is then placed in a furnace. The furnace is heated up slowly to a first temperature. Thereby the organic components of the laminate and the spacer-layer burn out. After burning-out is completed the temperature is risen upon sintering temperature. The temperatures for burning out and sintering are selected in dependence of the used organic and ceramic components. Conventional heating profiles and atmospheres are used. - After cooling the resulting ceramic helix is pulled off from the rod.

Ring-like helix with a curved axis as depicted in Fig. 4 can be manufactured, too by this method.

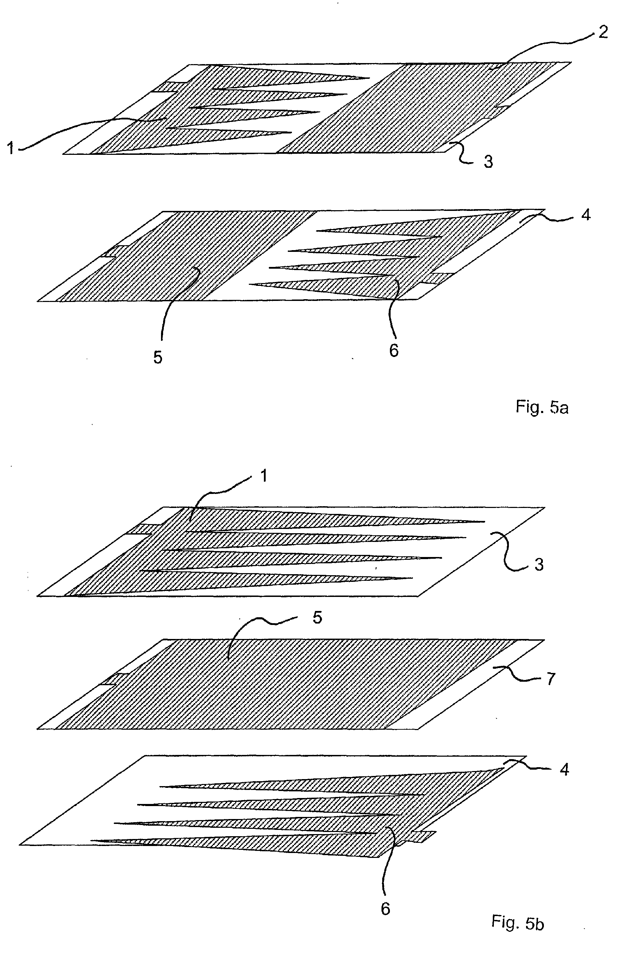

In Fig. 5a and 5b embodiments of electrode design are depicted. In Fig. 5a a first metal layer 1 serving as negative electrode and a second metal layer 2 serving as ground plate are provided on the surface of an upper green layer 3. A lower green layer 4 is provided with in a similar design with a third metal layer 5 serving as further ground plate and a fourth metal layer 6 serving as positive electrode. The upper green layer 3 is stacked above the lower green layer 4 in such way that the fourth metal layer 6 is placed below the second metal layer 2 and the third metal layer 5 is placed below the first metal layer 1.

In Fig. 5b there are provided an upper 3, a middle 7 and a lower green layer 4. The first metal layer 1 on the upper layer 3 serves here as positive electrode and a second metal layer 2 on the middle green layer 7 as ground plate. The fourth metal layer 6 of the lower green layer serves here as positive electrode.

The method according to the invention is now described in more detail by way of the following examples:

### Example 1

A multilayer of 38 layers of Solufill based on ultrahigh molecular weight polyethylene loaded with more than 92 wt % a soft PZT fine grained piezo ceramic powder with a layer thickness of 20 µm was made by a stacking and screenprinting process (="print on stack method"). The electrode printed has a triangle design to allow for a gradient of the electric field when a voltage is applied later on in the final product. Such electrode is used to be able to vary in one structure between contraction on one end and expansion on the other end of the final fired and poled piezoceramic. The green stacks are produced with a stacking pressure of 5 MPa at a lamination temperature of 120°C. The planar stack is cut into stripes which were then wound at elevated temperatures of minimum 60°C, around Alumina cores with a thickness of 1, 3, 5 and 10mm, covered by porous polyethylene foil. The spiral structure is covered with a release foil to prevent sticking to the vacuum sealing bags.

Every individual assembly is put into a vacuum-sealed bag. The bag is covered with a self-vulcanising silicone elastomer, which is water and temperature resistant. The said packages are heated in a water filled isostatic press at 155°C at 10, 20 or 40 MPa.

### Example 2

A multilayer of 38 layers of Solufill based on ultrahigh molecular weight polyethylene loaded with more than 92 wt % a soft PZT fine grained piezo ceramic powder with a layer thickness of 20 microns was made by a stacking and screen-printing process (print on stack method). The green stacks are produced with a stacking pressure of 20MPa at a lamination temperature of 120°C. The planar stack is cut into stripes which then were wound at elevated temperatures of minimum 60°C, around Alumina cores with a thickness of 1, 3, 5 and 10mm, covered by porous polyethylene foil. The spiral structure is covered with a release foil to prevent sticking to the vacuum sealing bags.

Every individual assembly is put into a vacuum-sealed bag. The bag is covered with a self-vulcanising silicone elastomer, which is water and temperature resistant. The said packages are heated in a water filled isostatic press at 155°C at 10, 20 or 40 MPa

### Example 3

A multilayer of 20 layers of Solufill based on ultrahigh molecular weight polyethylene loaded with more than 92 wt % a soft PZT fine grained piezo ceramic powder with a layer thickness of 10 microns was made by a stacking and screen-printing process (print on stack method). The green stacks are produced with a stacking pressure of 5MPa at a lamination temperature of 120°C. The planar stack is cut into stripes which then were wound at elevated temperatures of minimum 60°C, around Alumina cores with a thickness of 1, 3, 5 and 10mm, covered by porous polyethylene foil. The spiral structure is covered with a release foil to prevent sticking to the vacuum sealing bags.

Every individual assembly is put into a vacuum-sealed bag. The bag is covered with a self-vulcanising silicone elastomer, which is water and temperature resistant. The said packages are heated in a water filled isostatic press at 155°C at 10, 20 or 40 MPa.

### Example 4

A multilayer of 10 layers of tape cast piezoceramic green tapes with a layer thickness of 60 µm was made by a regular screenprinting, stacking, and lamination process. The green tape was achieved by tape casting an organic solvent-based slurry, comprising 800g PZT-powder, 40g polyvinylbutyral as a binder and 26 g dibuthylphthalate as a plasticizer. The dried sheets were screen printed, stacked and pre-laminated (5 MPa, 50 °C, 5-7 min) using position holes. After cutting the planar sheets into stripes they were wound at elevated temperatures of minimum 50 °C around Alumina cores (⌀ 5-10 mm), covered with e.g. porous Polyethylene foil of different thickness. Every individual assembly is put in a vacuum-sealed bag, which is water and temperature resistant for the isostatic lamination process. The isostatic lamination is done at 70 °C and 20 MPa for 10 minutes.

### Example 5

A multilayer of 10 layers of tape cast piezoceramic green tapes with a layer thickness of 90 µm was made by a regular screenprinting stacking, and lamination process. The green tape was achieved by tape casting an organic solvent based slurry, comprising 700 g PZT-powder, 70 g polyvinylbutyral as a binder and 70 g dibuthylphthalate as a plasticizer.

In contrast to example 4, the green tapes had a higher binder content and a higher plasticizer/binder ratio. The green tapes show here a strain to failure of 24%. The strain to failure or the longitudinal extensibility, respectively, of a green layer or green tape, respectively, was determined by conventional strain-strength measurement until failure by a mechanical testing machine at feed speed of 1 mm/min and a layer thickness of 90 µm. The free clamping length of the mechanical testing machine is 50 mm. The measurement is made at room temperature.

The dried sheets were screen printed, stacked and laminated (3-5 MPa, 70 °C, 7-10 min) using position holes. After cutting the planar sheets into stripes they were wound at elevated temperatures of minimum 50 °C around Alumina cores (⌀ 2-5 mm) without any coverage. Every individual assembly is put in an oven (70 °C) for 5 minutes for relaxation of the wounded/twisted structure. The helixes were removed from the Alumina core material. In another step they were wounded using a special support structure to fix the shape of a curved helix during binder burnout and sintering.

In all examples the laminate was debindered using 2 K/min to 200 °C and 0.3 K/min up to 600 °C. The sintering was done at 1190 °C for three hours. After sintering crack free and freestanding helixes were obtained.

## Claims

1. A method of making an laminated ceramic with a non-planar structure comprising the steps of:
1.1 providing flexible green layers comprising a ceramic powder being bound by an organic binder,
1.2 stacking of the green layers,
1.3 laminating of the stacked green layers in a laminating step (L1) by applying a pressure in the range of 0,2 to 25 MPa and a temperature in the range of 20 to 220°C,
1.4 forming the laminate into a non-planar structure,
1.5 laminating the formed laminate in a further laminating step (L2), wherein in the further laminating step (L2) a pressure being higher than the pressure applied in the laminating step (L1) and/or a temperature being higher than the temperature applied the laminating step (L1) is applied, and
1.6 burning out of the organic binder and sintering.

2. A method of claim 1 wherein the pressure applied in the further laminating step (L2) is in the range of 2 to 300 MPa.

3. A method of one of the preceding claims wherein the temperature applied in the further laminating step (L2) is in the range of 20 to 220°C.

4. A method of making an laminated ceramic with a non-planar structure comprising the steps of:
4.1 providing flexible green layers comprising a ceramic powder being bound by a organic binder, wherein the green layer has a longitudinal extensibility of at least 17%,
4.2 stacking of the green layers,
4.3 laminating of the stacked green layers in a laminating step (L1) by applying a pressure in the range of 0,2 to 300 MPa and a temperature in the range of 20 to 220°C,
4.4 forming the laminate into a non-planar structure, and
4.5 burning out of the organic binder and sintering.

5. A method of one of the preceding claims wherein the flexible green layer is manufactured by the doctor-blade-, ceramic-filled-thermoreversible-polymeric-gel-foil- or calendering-process.

6. A method of one of the preceding claims wherein the organic binder is selected form a group consisting of e.g. cellulose ether, polymerised alcohol, polymerised butyrol, acrylic resin, polyvinylacetate, polyethylene.

7. A method of one of the preceding claims wherein the green layer contains plasticizer.

8. A method of one of the preceding claims wherein the ratio of binder:plasticizer is in the range of 1:0,75 to 1:3,5.

9. A method of one of the preceding claims wherein the green layer has a thickness of 1 to 1000µm.

10. A method of one of the preceding claims wherein in the laminating step the pressure and/or temperature is adjusted to create a laminate with a porosity of at least 3,0 Vol.%

11. A method of one of the preceding claims wherein the pore space of the laminate is infiltrated with plasticizer before forming.

12. A method of one of the preceding claims wherein the laminate is formed at a temperature in the range of 50 to 150°C.

13. A method of one of the preceding claims wherein the laminate is formed into the non-planar structure by placing it on a support structure.

14. A method of one of the preceding claims wherein the laminate is fixed on the support structure, preferably by an adhesive tape.

15. A method of one of the preceding claims wherein a spacer made of organic material is placed between the support structure and the laminate.

16. A method of one of the preceding claims wherein the pressure in the laminating step (L1) and/or the further laminating step (L2) is performed by isostatic pressing.

17. A method of one of the preceding claims wherein before step 1.3 or 4.3 an electrode layer is applied on the surface of at least one of the green layers.

18. A layered ceramic device manufactured in accordance with a method of one of the preceding claims.

19. A layered ceramic device of claim 18 wherein the non-planar structure is a helical structure, preferably a structure with a curved helix-axis.

20. A layered ceramic device of claim 18 or 19 wherein the laminate comprises at least 2, preferably at least 10, ceramic layers.

21. A layered ceramic device of one of claims 18 to 20 being made of an electro-active ceramic material.
